# EUROPÄISCHE PATENTANMELDUNG

(11) **EP 2 413 679 A2**
(43) Veröffentlichungstag der Anmeldung: **01.02.2012**
(21) Anmeldenummer: 11173865.4
(22) Anmeldetag: 13.07.2011
(51) Int. Cl.: H05K 7/14

(54) **Elektronische Einschubbaugruppe zum Einschub in einen Baugruppenträger, Baugruppenträger sowie Anordnung mit einer Einschubbaugruppe und einem Baugruppenträger**

(30) Priorität: 27.07.2010 DE 102010032366
(71) Anmelder: Fujitsu Technology Solutions Intellectual Property GmbH, 80807 München (DE)
(72) Erfinder: Mühsam, Gerhard, 86343 Königsbrunn (DE)
(74) Vertreter: Epping - Hermann - Fischer

(57) **Zusammenfassung**

Die Erfindung betrifft eine elektronische Einschubbaugruppe (1) zum Einschub in einen Baugruppenträger (2), wobei die Einschubbaugruppe (1) zumindest eine elektronische Ausleseeinheit (3) aufweist, welche dazu eingerichtet ist, Informationen aus einer Informationsvorhaltungseinheit (4) im Baugruppenträger (2) ohne elektrischen Kontakt zum Baugruppenträger (2) auszulesen. Ferner betrifft die Erfindung einen Baugruppenträger (2), der zumindest eine Informationsvorhaltungseinheit (4) aufweist, welche dazu eingerichtet ist, Informationen vorzuhalten und mit einer Ausleseeinheit (3) der Einschubbaugruppe (1) ohne elektrischen Kontakt zur Einschubbaugruppe (1) zusammenzuwirken.

Ferner wird eine Anordnung mit einer Einschubbaugruppe (1) und einem Baugruppenträger (2) beschrieben.

## Beschreibung

Die Erfindung betrifft eine elektronische Einschubbaugruppe zum Einschub in einen Baugruppenträger, einen Baugruppenträger mit zumindest einem Einschubplatz zur Aufnahme zumindest einer elektronischen Einschubbaugruppe sowie eine Anordnung mit einer Einschubbaugruppe und einem Baugruppenträger.

Einschubbaugruppen werden häufig in Baugruppenträgern aufgenommen, wobei eine Vielzahl von Einschubbaugruppen zu einem größeren Rechensystem zusammengefasst werden kann. Eine derartige Situation liegt beispielsweise in Rechenzentren vor, in denen eine Vielzahl von Servern als Einschubbaugruppen in Serverracks als Baugruppenträgern aufgenommen ist. Im Servicefall muss eine Einschubbaugruppe schnell lokalisierbar sein, um eine Störung oder ein Fehlverhalten der Einschubbaugruppe möglichst schnell zu finden und beheben zu können. Doch auch zur Kommunikation zwischen mehreren Einschubbaugruppen ist eine Identifikation, Zuordnung und Unterscheidung einzelner Einschubbaugruppen notwendig. Ferner kann es erforderlich sein, dass eine Einschubbaugruppe Informationen über den Baugruppenträger erhält, beispielsweise, um ihr Betriebsverhalten an die Gegebenheiten des Baugruppenträgers anzupassen.

Gerade bei einer großen Anzahl von Einschubbaugruppen ist es gängig, jede Einschubbaugruppe ihrem entsprechenden Baugruppenträger oder gar ihrem Einschubplatz im Baugruppenträger über eine Kennung zuzuordnen. Diese Kennung kann abgefragt werden und führt zum Baugruppenträger und zum Einschubplatz der Einschubbaugruppe.

Zur Erzeugung einer derartigen Kennung verfügt jeder Einschubplatz im Baugruppenträger in der Regel über eine Ausleseeinheit zur Erfassung einer lesbaren Markierung an einer Einschubbaugruppe oder über einen elektrischen Anschluss zur Kodierung einer entsprechenden Einschubbaugruppe. Die Ausstattung eines Baugruppenträgers mit entsprechenden elektronischen Bauelementen und Einheiten ist kostenaufwändig. Die Baugruppenträger weisen zudem oft ein Bussystem auf, zum Beispiel einen Managementbus. Die für jede Einschubbaugruppe erzeugte Kennung kann über das Bussystem an eine Verwaltungseinheit weitergeben werden. Auch die Ausstattung eines Baugruppenträgers mit einem derartigen Bussystem ist kostenaufwändig.

Eine andere Möglichkeit zur Zuordnung einer Einschubbaugruppe zu ihrem jeweiligen Einschubplatz im Baugruppenträger ist die Eingabe einer entsprechenden Information in einem Servicemodul (Frontend) des Baugruppenträgers. Ein Nachteil dieser Möglichkeit besteht darin, dass jedes Mal Informationen umprogrammiert werden müssen, wenn sich Veränderungen in der Zuordnung einer entsprechenden Einschubbaugruppe zu einem Einschubplatz des Baugruppenträgers ergeben.

Es ist eine Aufgabe der Erfindung, eine Einschubbaugruppe, einen Baugruppenträger sowie eine Anordnung mit einer Einschubbaugruppe und einem Baugruppenträger der eingangs genannten Art zu beschreiben, welche eine vereinfachte Identifikation und Zuordnung einer Einschubbaugruppe zu einem Baugruppenträger ermöglichen.

In einem ersten Aspekt wird die Aufgabe durch eine elektronische Einschubbaugruppe zum Einschub in einen Baugruppenträger gelöst, wobei die Einschubbaugruppe zumindest eine elektronische Ausleseeinheit aufweist, welche dazu eingerichtet ist, Informationen aus einer Informationsvorhaltungseinheit im Baugruppenträger ohne elektrischen Kontakt zum Baugruppenträger auszulesen.

Bei dieser Lösung erfasst die Einschubbaugruppe eigenständig vorgehaltene Informationen des Baugruppenträgers. Eine entsprechende Ausleseeinheit sitzt dabei in der Einschubbaugruppe und nicht im Baugruppenträger. Es werden Datenverarbeitungseinheiten und -prozesse der Einschubbaugruppe ausgenützt zur Erfassung und Verarbeitung von Informationen aus dem Baugruppenträger, in dem die Einschubbaugruppe eingeschoben ist. Die Informationen können von der Einschubbaugruppe selbst interpretiert und/oder an eine Verwaltungseinheit zur Steuerung und Verwaltung von Einschubbaugruppen im Baugruppenträger für Servicezwecke weitergegeben werden. Eine Weitergabe kann über Netzwerk, beispielsweise LAN (local area network), erfolgen. Die Lösung macht keine aufwändige Verdrahtung eines Baugruppenträgers notwendig. Ein Bussystem zur Erfassung einer Kennung einer Einschubbaugruppe und Zuordnung der Einschubbaugruppe zu ihrem Einschubplatz im Baugruppenträger fällt weg. Eine Verwendung dieser Lösung ergibt sich beispielsweise in einem Serverrack, in dem mehrere Server eingeschoben sind, wobei zu Wartungszwecken der Server deren Einschubplätze erkannt und zugeordnet werden.

Gemäß einer ersten Ausführungsform der Einschubbaugruppe umfasst die Ausleseeinheit einen Strichkodeleser. In einer zweiten Ausführungsform der Einschubbaugruppe umfasst die Ausleseeinheit einen RFID-Leser (RFID = radio frequency identification). Bei der ersten und zweiten Ausführungsform ist ein Auslesen einer Information aus dem Baugruppenträger berührungslos durchführbar. Berührungslos bedeutet dabei, dass die Einschubbaugruppe und der Baugruppenträger zwischen der Ausleseeinheit der Einschubbaugruppe und der Informationsvorhaltungseinheit des Baugruppenträgers weder einen elektrischen noch einen mechanischen Kontakt haben. Dies hat den Vorteil, dass Toleranzen zwischen der Einschubbaugruppe und dem Baugruppenträger keinen oder nur einen unwesentlichen Einfluss auf das Zusammenspiel zwischen Ausleseeinheit und Informationsvorhaltungseinheit haben. Denn es ist kein direkter Kontakt zwischen den Komponenten notwendig. Derartige Toleranzen ergeben sich insbesondere durch unterschiedliche Ausgestaltung von Befestigungssystemen im Baugruppenträger oder bei Verwendung von Einschubbaugruppen mit unterschiedlichen Höhenabmessungen.

Ferner besitzen berührungslos arbeitende Systeme dieser Art die Möglichkeit einer einfachen Umprogrammierung oder Umkodierung, sodass die Ausleseeinheit der Einschubbaugruppe entsprechend an eine Veränderung der Konfiguration im Baugruppenträger angepasst werden kann. So ist eine Umprogrammierung der Ausleseeinheit beispielsweise auf ein anderes Übertragungsprotokoll oder eine andere Kodierung von Informationen möglich. Zudem kann die Ausleseeinheit an Informationen unterschiedlichster Art angepasst werden. Beispielsweise wird eine Information über die Platznummer des Einschubplatzes um weitere Informationen, wie verfügbare Höheneinheiten im Baugruppenträger, Typ und Identifikation des Baugruppenträgers, Herstellungsdaten oder Temperaturdaten innerhalb des Baugruppenträgers erweitert. Die Ausleseinheit kann dann entsprechend umprogrammiert werden, sodass sie alle verfügbaren Informationen auslesen kann.

In einer dritten Ausführungsform der Einschubbaugruppe umfasst die Ausleseinheit eine Mehrzahl von Kontaktelementen, welche dazu eingerichtet sind, bei Zusammenwirken mit Gegenkontaktelementen der Informationsvorhaltungseinheit im Baugruppenträger elektrische Informationen zu erzeugen. Bevorzugt sind bei dieser Ausführungsform der Einschubbaugruppe die Kontaktelemente mechanisch beweglich zum Schließen elektrischer Kontakte innerhalb der Ausleseeinheit. Eine elektrische Information kann dadurch erzeugt werden, dass die Kontaktelemente jeweils bei Zusammenwirken mit Gegenkontaktelementen im Baugruppenträger mechanisch verschoben werden. Elektrische Kontakte, welche den Kontaktelementen zugeordnet sind, werden durch die mechanische Bewegung der Kontaktelemente folglich entweder geschlossen oder offen gehalten. Dadurch ist es möglich, einen elektrischen Strom und/oder eine elektrische Spannung an einem jeweiligen Kontakt innerhalb der Ausleseeinheit zu erzeugen oder zu verändern und somit eine elektrische Information zu erzeugen.

Zur Verarbeitung von Informationen, welche aus dem Baugruppenträger ausgelesen werden können, kann die Ausleseeinheit neben einer Informationserfassungseinheit auch eine Informationsverarbeitungseinheit aufweisen. Dabei kann beispielsweise eine Analog-Digital-Wandlung von analogen elektrischen Signalen erfolgen, sodass daraus digitale Signale erzeugt werden. Diese digitalen Signale können anschließend an eine Logikeinheit weitergegeben werden. Die Logikeinheit kann die Signale weiterverarbeiten und/oder über Netzwerk an eine weitere Verwaltungseinheit übergeben. Es ist auch denkbar, dass eine entsprechende Verwaltungseinheit in einer Einschubbaugruppe selbst angeordnet ist.

In einem weiteren Aspekt wird die Aufgabe durch einen Baugruppenträger mit zumindest einem Einschubplatz zur Aufnahme zumindest einer elektronischen Einschubbaugruppe gelöst, wobei der Baugruppenträger zumindest eine Informationsvorhaltungseinheit aufweist, welche dazu eingerichtet ist, Informationen vorzuhalten und mit einer Ausleseeinheit der Einschubbaugruppe ohne elektrischen Kontakt zur Einschubbaugruppe zusammenzuwirken. Der Baugruppenträger umfasst dabei lediglich Mittel zur Vorhaltung oder Speicherung von Informationen. Eine Erfassung und Auswertung dieser Informationen erfolgt nicht durch den Baugruppenträger, sondern durch eine Einschubbaugruppe, welche in den Baugruppenträger eingeschoben ist. Die Einschubbaugruppe identifiziert sich selbst durch Auslesen der entsprechenden Informationen aus dem Baugruppenträger. Hinterlegte Informationen können beispielsweise die Einschubplatznummer, verfügbare Höheneinheiten, Typ und Identifikation des Baugruppenträgers, Herstellungsdaten oder Temperaturdaten im Baugruppenträger umfassen. Der Baugruppenträger selbst ist passiv. Somit ist keine Einrichtung eines Bussystems zur Identifikation einer Einschubbaugruppe im Baugruppenträger notwendig. Die Lösung erlaubt eine einfache Konfiguration von Einschubbaugruppen und spart Kosten des Baugruppenträgers.

Gemäß einer ersten Ausführungsform des Baugruppenträgers umfasst die Informationsvorhaltungseinheit einen Strichkodestreifen. Gemäß einer zweiten Ausführungsform des Baugruppenträgers umfasst die Informationsvorhaltungseinheit einen RFID-Antwortsender (RFID transponder). Die erste und zweite Ausführungsform des Baugruppenträgers entsprechen den Gegenstücken zu den ersten und zweiten Ausführungsformen einer Ausleseeinheit in einer Einschubbaugruppe als Strichkodeleser oder RFID-Leser. Durch derartiges Einrichten der Informationsvorhaltungseinheit ist ein berührungsloses Erfassen der Informationen aus dem Baugruppenträger über eine Ausleseeinheit der Einschubbaugruppe möglich. Dabei ergeben sich die bereits genannten Vorteile. Wenn die auszulesenden Informationen umgeändert werden sollen, ist es beispielsweise möglich, einen Strichkodestreifen zur Kodierung eines Einschubplatzes im Baugruppenträger durch einen neuen Strichkodestreifen zu ersetzen oder den RFID-Antwortsender in einem Einschubplatz des Baugruppenträgers durch ein geeignetes Programmiergerät umzuprogrammieren oder ebenfalls zu ersetzen.

Gemäß einer dritten Ausführungsform des Baugruppenträgers umfasst die Informationsvorhaltungseinheit eine Mehrzahl von Ausnehmungen, welche dazu eingerichtet sind, mit Kontaktelementen der Ausleseeinheit der Einschubbaugruppe zusammenzuwirken und welche derart unterschiedliche Tiefen aufweisen, dass Informationen mechanisch kodiert sind. Bei Zusammenwirken mit Kontaktelementen der Einschubbaugruppe, insbesondere mit Kontaktelementen, welche mechanisch beweglich sind, kann somit eine zumindest auf Seiten des Baugruppenträgers rein mechanische Kodierung erfolgen. Pro Einschubplatz sind Ausnehmungen unterschiedlicher Anzahl und/oder unterschiedlicher Tiefe in einem charakteristischen Muster angeordnet. Die Kontaktelemente der Einschubbaugruppe können somit unterschiedlich mechanisch bewegt, insbesondere eingedrückt werden und erzeugen jeweils eine unterschiedliche elektrische Kontaktierung innerhalb der Ausleseeinheit der Einschubbaugruppe. Die mechanische Kodierung wird somit in ein elektrisches Signal oder Signalmuster umgesetzt. Jeder Einschubplatz kann im Baugruppenträger eine Platte mit Ausnehmungen aufweisen, welche in unterschiedlicher Anzahl und/oder mit unterschiedlicher Tiefe vorbereitet sind.

Bevorzugt ist die Informationsvorhaltungseinheit eine passive Einheit ohne Energieversorgung. Es ist keine

Versorgungselektronik im Baugruppenträger notwendig. Der Baugruppenträger verbraucht keine Energie und ist einfach im Aufbau. Dies erlaubt eine weitere Kostenreduzierung.

In einem weiteren Aspekt wird die Aufgabe durch eine Anordnung mit einer Einschubbaugruppe und einem Baugruppenträger der vorgenannten Art und Weise gelöst. Auch hier ergeben sich die bereits genannten und erläuterten Vorteile.

Nachfolgend wird die Erfindung anhand mehrerer Ausführungsbeispiele anhand von Zeichnungen näher erläutert.

Es zeigen:
- Figur 1: eine perspektivische Darstellung einer Anordnung von Einschubbaugruppen in einem Baugruppenträger,
- Figur 2: ein schematisiertes Schnittbild einer ersten Ausführungsform gemäß einer ersten Schnittachse aus Figur 1,
- Figur 3: ein schematisiertes Schnittbild einer detaillierten Ausführungsform aus Figur 2 gemäß einer zweiten Schnittachse aus Figur 1,
- Figur 4: eine schematisierte Darstellung einer weiteren Ausführungsform, wobei Einschubbaugruppe und Baugruppenträger nicht Zusammenwirken, und
- Figur 5: die Ausführungsform gemäß Figur 4, wobei Einschubbaugruppe und Baugruppenträger zusammenwirken.

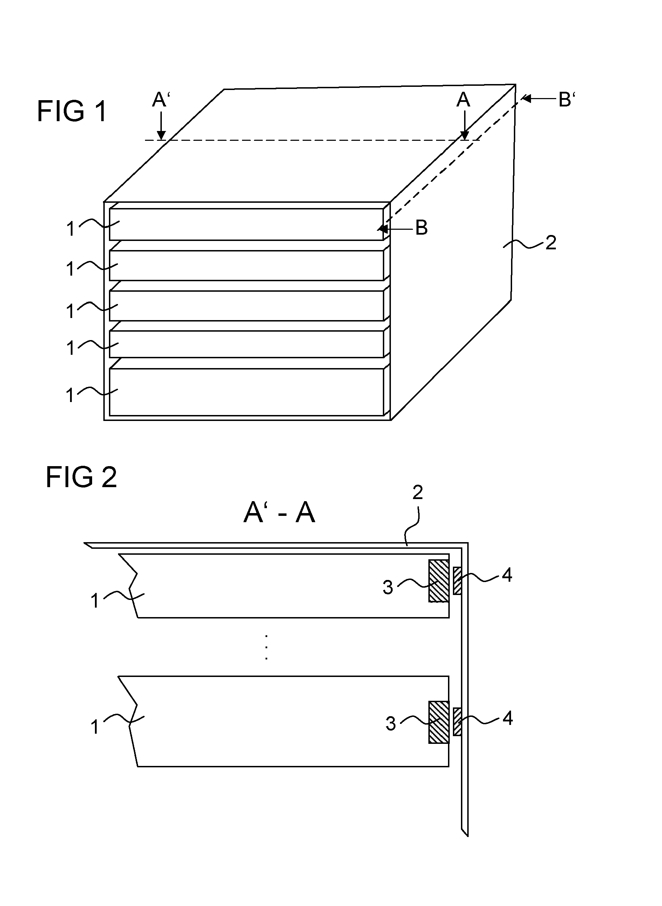

Figur 1 zeigt einen Baugruppenträger 2, in dem mehrere Einschubbaugruppen 1 eingeschoben und aufgenommen sind. Die Einschubbaugruppen 1 können beispielsweise Server, insbesondere Bladeserver, darstellen und bilden gemeinsam im Baugruppenträger 2 ein Rechnersystem. Der Baugruppenträger 2 ist beispielsweise ein Serverrack zum Aufstellen der Einschubbaugruppen 1 in einem Rechenzentrum.

Figur 2 zeigt eine schematisierte Schnittdarstellung gemäß der Schnittachse A'-A aus Figur 1. Dabei zeigt Figur 2 eine erste Ausführungsform der Einschubbaugruppen 1 und des Baugruppenträgers 2. Die Einschubbaugruppen 1 sind im Baugruppenträger 2 aufgenommen und weisen jeweils eine Ausleseeinheit 3 auf. Bekannte Mittel zum Befestigen der Einschubbaugruppen 1 im Baugruppenträger 2 sind vorgesehen und eingesetzt, jedoch hier nicht dargestellt.

Der Baugruppenträger 2 weist Informationsvorhaltungseinheiten 4 auf, welche gemäß dieser Ausführung derart am jeweiligen Einschubplatz der Einschubbaugruppen 1 angeordnet sind, dass sie mit den Ausleseeinheiten 3 der Einschubbaugruppen 1 zusammenwirken können. Die Informationsvorhaltungseinheiten 4 stellen Informationen bereit, welche von den Ausleseeinheiten 3 der Einschubbaugruppen 1 ausgelesen werden können. Derartige Informationen betreffen beispielsweise die Identifikation der Einschubplätze im Baugruppenträger 2, verfügbare Höheneinheiten im Baugruppenträger 2, Herstellungs- und Identifikationsdaten des Baugruppenträgers 2 selbst, oder Temperaturdaten innerhalb des Baugruppenträgers 2.

In der Ausführung gemäß Figur 2 wirken die Ausleseeinheiten 3 und die Informationsvorhaltungseinheiten 4 berührungslos zusammen. Das bedeutet, dass die Ausleseeinheiten 3 und Informationsvorhaltungseinheiten 4 weder einen elektrischen noch einen mechanischen Kontakt haben. Gemäß der Ausführung in Figur 2 sind die Ausleseeinheiten 3 beispielsweise Strichkodeleser oder RFID-Leser und die Informationsvorhaltungseinheiten 4 Strichkodestreifen oder RFID-Antwortsender. Gemäß einem Verfahren zur Identifikation einer Einschubbaugruppe 1 in einem Baugruppenträger 2 kann eine Ausleseeinheit 3 der Einschubbaugruppe 1 während oder nach Einschieben der Einschubbaugruppe 1 mit der Informationsvorhaltungseinheit 4 im Baugruppenträger 2 zusammenwirken, Informationen auslesen, diese verarbeiten und gegebenenfalls die Informationen an eine Verwaltungs- oder Serviceeinheit weitergeben.

Im Falle einer Ausführung der Komponenten 3 und 4 als Strichkodeleser und -streifen erfolgt die Erfassung von Informationen aus den Informationsvorhaltungseinheiten 4 beispielsweise durch Abtasten der Informationsvorhaltungseinheiten 4 über ein von den Ausleseeinheiten 3 ausgestrahltes Laserlicht. Das Laserlicht wird durch charakteristische Muster von Hell/Dunkel-Wechseln der Strichkodestreifen in den Informationsvorhaltungseinheiten 4 charakteristisch in die Ausleseeinheiten 3 zurückreflektiert, wobei die erfassten Informationen elektrisch dekodiert und verarbeitet werden können.

Gemäß der Ausführung der Komponenten 3 und 4 als RFID-Leser und -Antwortsender, erfolgt das Auslesen der Informationen aus den Informationsvorhaltungseinheiten 4 über die Ausleseeinheiten 3 gemäß der von der RFID-Technik bekannten Art und Weise. Dabei senden die Ausleseeinheiten 3 beispielsweise ein elektromagnetisches Wechselfeld aus, wodurch Empfangsantennen in den Informationsvorhaltungseinheiten 4 elektrisch angeregt werden, sodass eine Logikeinheit, insbesondere ein Mikrochip in den Informationsvorhaltungseinheiten 4 elektrisch aktiv wird und elektrische Informationen in das eingestrahlte elektromagnetische Wechselfeld einkoppelt und/oder die Reflexion der elektromagnetischen Welle beeinflusst, sodass die Ausleseeinheiten 3 elektrische Signale dekodieren und weiterverarbeiten können.

Der Vorteil der berührungslosen Arbeitsweise der Komponenten 3 und 4 besteht darin, dass ein fehlerfreier Betrieb aufrechterhalten bleibt, wenn der Baugruppenträger 2 und/oder die Einschubbaugruppen 1, insbesondere durch häufiges Öffnen des Baugruppenträgers 2 zu Wartungszwecken, verschmutzen. Auch ein häufiger Wechsel und Ein- sowie Ausbau von Einschubbaugruppen 1 im Baugruppenträger 2 und ein damit verbundener Verschleiß von Elementen beeinflusst die Arbeitsweise der Komponenten 3 und 4 nicht. Ferner kann eine Toleranz zwischen einer Einschubbaugruppe 1 und einem Einschubplatz im Baugruppenträger 2, welche sich durch Befestigungselemente zum Einbau der Einschubbaugruppe 1 im Baugruppenträger 2 oder durch unterschiedliche Höhe von Einschubbaugruppen 1 ergibt, in gewissem Rahmen durch das berührungslose Arbeiten der Komponenten 3 und 4 ausgeglichen werden.

In Figur 2 sind beispielhaft zwei Einschubbaugruppen 1 angedeutet, wobei die obere Einschubbaugruppe 1 eine geringere Höhe aufweist als die untere Einschubbaugruppe 1. Eine Anwendung einer Informationsweitergabe vom Baugruppenträger 2 an die entsprechenden Einschubbaugruppen 1 kann beispielsweise darin bestehen, den beiden Einschubbaugruppen 1 nicht nur eine Identifikation ihrer Einschubplätze, sondern auch eine Identifikation verfügbarer Höheneinheiten im Baugruppenträger 2 mitzuteilen. So können die beiden Einschubbaugruppen 1 beispielsweise Informationen erfassen, wie viele Höheneinheiten im Baugruppenträger 2 verbaut werden können. Diese Informationen können an eine Verwaltungseinheit, welche entweder in einer oder beiden der Einschubbaugruppen 1 oder separat angeordnet ist, weitergegeben werden. Die Verwaltungseinheit kann dann erfassen, wie viel Platz noch im Baugruppenträger 2 frei ist und wie viele weitere Einschubbaugruppen 1 an welcher Position im Baugruppenträger 2 eingeschoben werden können.

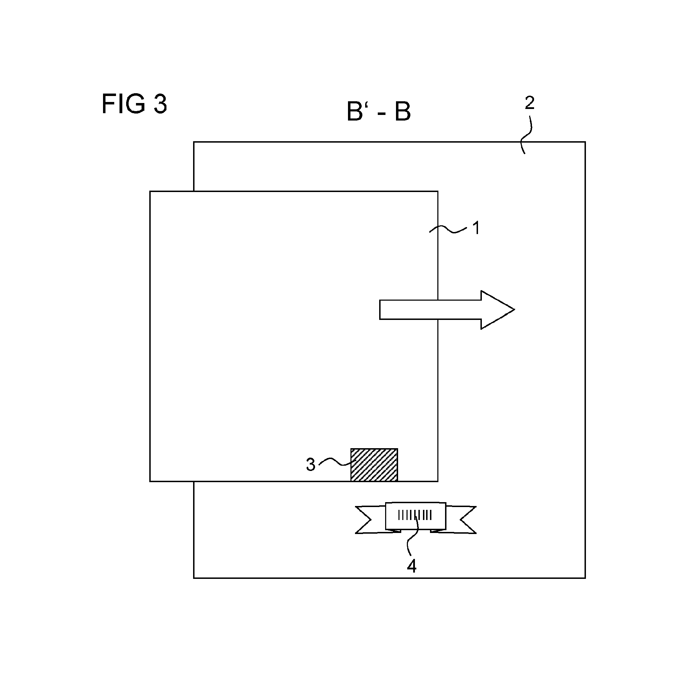

Figur 3 zeigt eine schematisierte Darstellung einer detaillierten Ausführungsform aus Figur 2 gemäß der Schnittachse B'-B aus Figur 1. Eine Einschubbaugruppe 1 wird dabei in Pfeilrichtung in den Baugruppenträger 2 eingeschoben. Im Baugruppenträger 2 ist auf Höhe des Einschubplatzes der Einschubbaugruppe 1 eine Informationsvorhaltungseinheit 4 angeordnet, welche in dieser Ausführung einen Strichkodestreifen darstellt. Ferner weist die Einschubbaugruppe 1 eine Ausleseeinheit 3 auf, welche derart angeordnet ist, dass sie mit der Informationsvorhaltungseinheit 4 im Baugruppenträger 2 zusammenwirken kann. In der in Figur 3 dargestellten Position der Einschubbaugruppe 1 ist die Ausleseeinheit 3 noch nicht vollkommen auf Höhe und deckungsgleich mit der Informationsvorhaltungseinheit 4. Die Einschubbaugruppe 1 kann in Pfeilrichtung weiter eingeschoben werden, sodass die Ausleseeinheit 3 an der Informationsvorhaltungseinheit 4 entlang geführt wird. Mit Hilfe eines Laserstrahls der Ausleseeinheit 3 kann der Strichkodestreifen der Informationsvorhaltungseinheit 4 ausgelesen werden.

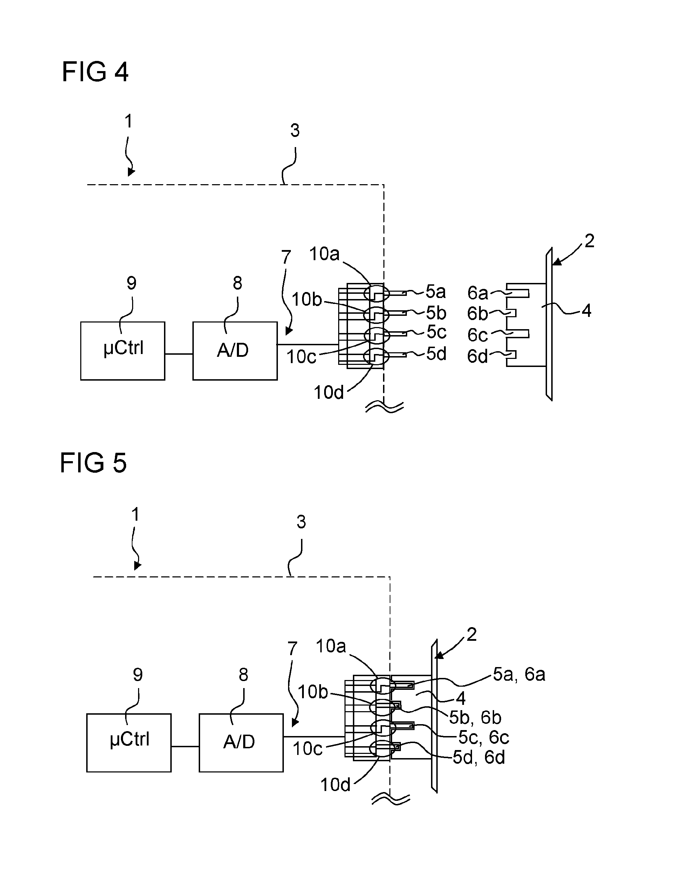

Figur 4 zeigt eine schematisierte Darstellung einer weiteren Ausführungsform einer Ausleseeinheit 3 einer Einschubbaugruppe 1 und einer Informationsvorhaltungseinheit 4 eines Baugruppenträgers 2, wobei die Einschubbaugruppe 1 und der Baugruppenträger 2 nicht zusammenwirken. Gemäß der Ausführungsform in Figur 4 sind die Komponenten 3 und 4 derart ausgeführt, dass ein Auslesen von Informationen im Unterschied zu den Ausführungsformen gemäß den Figuren 2 und 3 nicht berührungslos erfolgt.

Die Ausleseeinheit 3 weist mehrere Kontaktelemente 5a bis 5d auf, welche hier als Kontaktpins ausgeführt sind. Die Kontaktelemente 5a bis 5d sind derart mechanisch beweglich, dass sie in das Gehäuse der Ausleseeinheit 3 hineingedrückt werden können. Bei Eindrücken eines oder mehrerer der Kontaktelemente 5a bis 5d schließt ein entsprechender Kontakt 10a bis 10d, sodass ein elektrisches Signal am jeweiligen Kontakt 10a bis 10d erzeugt oder verändert wird und über elektrische Leitungen 7 an einen Analog-Digital-Umsetzer 8 weitergeleitet wird. Der Analog-Digital-Umsetzer 8 wandelt die analogen Signale in digitale Signale um und sendet diese schließlich an einen Mikrocontroller 9 zur weiteren Verarbeitung und/oder Weitergabe an eine Verwaltungseinheit (nicht dargestellt).

Die Informationsvorhaltungseinheit 4 des Baugruppenträgers 2 ist in diesem Ausführungsbeispiel derart eingerichtet, dass Gegenkontaktelemente 6a bis 6d als Ausnehmungen zum Zusammenwirken mit Kontaktelementen 5a bis 5d eingerichtet sind. Die Ausnehmungen besitzen unterschiedliche Tiefen. Ein Einschubplatz kann somit durch unterschiedliche Ausführung und Anordnung unterschiedlicher Ausnehmungen kodiert werden. Auch weitere Informationen gemäß der bereits erläuterten Art können dadurch kodiert werden.

Beispielsweise besitzen die Gegenkontaktelemente 6a und 6c gemäß Figur 4 Ausnehmungen, welche tiefer ausgeführt sind als Ausnehmung der Gegenkontaktelemente 6b und 6d. Die Gegenkontaktelemente 6a bis 6d wirken dabei auf unterschiedliche Art und Weise mit den Kontaktelementen 5a bis 5d zusammen, was in Figur 5 näher erläutert wird.

Figur 5 zeigt die Ausführungsform gemäß Figur 4 während des Zusammenwirkens der Ausleseeinheit 3 der Einschubbaugruppe 1 mit der Informationsvorhaltungseinheit 4 des Baugruppenträgers 2. Aufgrund der speziellen Anordnung der Gegenkontaktelemente 6a bis 6d mit unterschiedlich dimensionierten Ausnehmungen wird ein Teil der Kontaktelemente 5a bis 5d mechanisch eingedrückt und der andere Teil nicht. Insbesondere tauchen die Kontaktelemente 5a und 5c in die tiefen Ausnehmungen 6a und 6c und werden mechanisch nicht oder nur kaum bewegt. Anders verhält es sich bei den Kontaktelementen 5b und 5d, welche in die Ausnehmungen 6b und 6d geringerer Tiefe eintauchen und von Gegenkontaktelementen 6b und 6d in das Gehäuse der Ausleseeinheit 3 eingedrückt werden. Die Kontakte 10a und 10c sind offen, die Kontakte 10b und 10d sind geschlossen.

Beispielsweise liegt an allen Kontakten 10a bis 10d eine Spannung der Einschubbaugruppe 1, welche im Falle geschlossener Kontakte 10b und 10d verändert, beispielsweise auf Massepotential herabgesetzt, wird und im Falle offener Kontakte 10a und 10c als Leerlaufpotential erhalten bleibt. Somit wird durch mechanisches Zusammenwirken der Kontaktelemente 5a bis 5d und der Gegenkontaktelemente 6a bis 6d ein elektrisches Signalmuster in der Ausleseeinheit 3 erzeugt, welches über den Analog-Digital-Umsetzer 8 erfasst und im Mikrocontroller 9 verarbeitet und gegebenenfalls weitergeleitet werden kann. Auf diese Art und Weise können beispielsweise unterschiedliche Einschubplätze des Baugruppenträgers 2 mechanisch kodiert und elektrisch dekodiert werden.

In nicht dargstellten Ausführungsformen können die Ausleseeinheit 3 und die Informationsvorhaltungseinheit 4 auch eine Kombination von berührungslos arbeitenden oder elektrisch kontaktierenden Komponenten gemäß den erläuterten Ausführungsformen aufweisen. Dies kann je nach Anforderung an das Auslesen von Informationen aus dem Baugruppenträger 2 angepasst werden. Auch die einzelnen Ausführungsformen sind lediglich beispielhaft in der Auswahl und Ausführung aller Komponenten.

### Bezugszeichenliste

- 1: Einschubbaugruppe
- 2: Baugruppenträger
- 3: Ausleseeinheit
- 4: Informationsvorhaltungseinheit
- 5a bis 5d: Kontaktelemente
- 6a bis 6d: Gegenkontaktelemente
- 7: elektrische Leitung
- 8: Analog-Digital-Umsetzer
- 9: Mikrocontroller
- 10a bis 10d: elektrische Kontakte
- A'-A: Schnittgerade
- B'-B: Schnittgerade

## Patentansprüche

1. Elektronische Einschubbaugruppe (1) zum Einschub in einen Baugruppenträger (2), wobei die Einschubbaugruppe (1) zumindest eine elektronische Ausleseeinheit (3) aufweist, welche dazu eingerichtet ist, Informationen aus einer Informationsvorhaltungseinheit (4) im Baugruppenträger (2) ohne elektrischen Kontakt zum Baugruppenträger (2) auszulesen.

2. Elektronische Einschubbaugruppe (1) nach Anspruch 1, wobei die Ausleseeinheit (3) einen Strichkodeleser umfasst.

3. Elektronische Einschubbaugruppe (1) nach Anspruch 1 oder 2, wobei die Ausleseeinheit (3) einen RFID-Leser umfasst.

4. Elektronische Einschubbaugruppe (1) nach einem der Ansprüche 1 bis 3, wobei die Ausleseeinheit (3) eine Mehrzahl von Kontaktelementen (5a, 5b, 5c, 5d) umfasst, welche dazu eingerichtet sind, bei Zusammenwirken mit Gegenkontaktelementen (6a, 6b, 6c, 6d) der Informationsvorhaltungseinheit (4) im Baugruppenträger (2) elektrische Informationen zu erzeugen, wobei die Kontaktelemente (5a, 5b, 5c, 5d) mechanisch beweglich sind zum Schließen elektrischer Kontakte (10a, 10b, 10c, 10d) innerhalb der Ausleseeinheit (3).

5. Baugruppenträger (2) mit zumindest einem Einschubplatz zur Aufnahme zumindest einer elektronischen Einschubbaugruppe (1), wobei der Baugruppenträger (2) zumindest eine Informationsvorhaltungseinheit (4) aufweist, welche dazu eingerichtet ist, Informationen vorzuhalten und mit einer Ausleseeinheit (3) der Einschubbaugruppe (1) ohne elektrischen Kontakt zur Einschubbaugruppe (1) zusammenzuwirken.

6. Baugruppenträger (2) nach Anspruch 5, wobei die Informationsvorhaltungseinheit (4) einen Strichkodestreifen umfasst.

7. Baugruppenträger (2) nach Anspruch 5 oder 6, wobei die Informationsvorhaltungseinheit (4) einen RFID-Antwortsender umfasst.

8. Baugruppenträger (2) nach einem der Ansprüche 5 bis 7, wobei die Informationsvorhaltungseinheit (4) eine Mehrzahl von Ausnehmungen (6a, 6b, 6c, 6d) umfasst, welche dazu eingerichtet sind, mit Kontaktelementen (5a, 5b, 5c, 5d) der Ausleseeinheit (3) der Einschubbaugruppe (1) zusammenzuwirken und welche derart unterschiedliche Tiefen aufweisen, dass Informationen mechanisch kodiert sind.

9. Baugruppenträger (2) nach einem der Ansprüche 5 bis 8, wobei die Informationsvorhaltungseinheit (4) eine passive Einheit ohne Energieversorgung ist.

10. Anordnung mit einer Einschubbaugruppe (1) nach einem der Ansprüche 1 bis 4 und einem Baugruppenträger (2) nach einem der Ansprüche 5 bis 9.
